# FASCICULE DE BREVET EUROPEEN

(11) **EP 4 391 785 B1**
(45) Date de publication et mention de la délivrance du brevet: **25.06.2025**
(21) Numéro de dépôt: 23218365.7
(22) Date de dépôt: 19.12.2023
(51) Int. Cl.: H10N 60/81, H10N 60/12, H10N 60/01

(54) **RÉALISATION D'UN DISPOSITIF QUANTIQUE À JONCTION JOSEPHSON ENROBANTE**
REALISIERUNG EINES QUANTENBAUELEMENTS MIT ÜBERLAPPENDEM JOSEPHSON-ÜBERGANG
REALIZATION OF A QUANTUM DEVICE WITH OVERLAP JOSEPHSON JUNCTION

(30) Priorité: 20.12.2022 FR 2213899
(43) Date de publication de la demande: 26.06.2024
(73) Titulaire: Commissariat à l'Energie Atomique et aux Energies Alternatives, 75015 Paris (FR)
(72) Inventeur: MOULIN, Maxime, 38054 Grenoble Cedex 09 (FR); CASSE, Mikael, 38054 Grenoble Cedex 09 (FR); GAILLARD, Frédéric, 38054 Grenoble Cedex 09 (FR); MORAND, Yves, 38054 Grenoble Cedex 09 (FR)
(74) Mandataire: Brevalex

(56) Documents cités:
- US-B1- 9 455 391
- KELLER A J ET AL: "Al transmon qubits on silicon-on-insulator for quantum device integration", APPLIED PHYSICS LETTERS, vol. 111, 042603, 25 July 2017 (2017-07-25), XP012220336, DOI: 10.1063/1.4994661
- PATEL U ET AL: "Coherent Josephson phase qubit with a single crystal silicon capacitor", APPLIED PHYSICS LETTERS, vol. 102, 012602, 9 January 2013 (2013-01-09), XP012168726, DOI: 10.1063/1.4773996
- VERJAUW J ET AL: "Path toward manufacturable superconducting qubits with relaxation times exceeding 0.1 ms", NPJ QUANTUM INFORMATION, vol. 8, 93, 9 August 2022 (2022-08-09), XP093064414, DOI: 10.1038/s41534-022-00600-9

## Description

### DOMAINE TECHNIQUE ET ART ANTERIEUR

La présente demande se rapporte au domaine des dispositifs quantiques munis d'au moins une structure comportant une jonction Josephson associée à un résonateur ainsi qu'à un procédé de fabrication d'une telle structure.

Les résonateurs, en particulier les résonateurs supraconducteurs, sont des composants permettant la lecture des états de spin de dispositif quantiques mettant en œuvre des bits quantiques couramment appelés « qubits » ou « Qbits ».

Un résonateur d'un dispositif quantique est typiquement sous forme d'au moins une ligne de transmission hyperfréquence conçue pour être le lieu d'oscillations résonantes dans certaines conditions particulières.

Le calcul quantique nécessite des opérations à faible perte des résonateurs.

Des dispositifs quantiques à qubits formés par le biais de jonctions Josephson couplées à un résonateur supraconducteur et dans lesquels l'information quantique peut être échangée via un photon sont apparus.

Le document « Path toward manufacturable superconducting qubits with relaxation times exceeding 0.1 ms » de J. - Verjauw et al., npj Quantum Information volume 8, article no. à 93 (2022), prévoit la réalisation d'un dispositif quantique avec une jonction Josephson ayant un agencement particulier et qui est mise en œuvre sur un substrat compatible à l'intégration de composants en technologie CMOS (« Complementary Metal Oxide Semiconductor » ou « semi-conducteur à oxyde métallique complémentaire »). La réalisation de la jonction Josephson comprend le dépôt de matériau supraconducteur tel que l'aluminium sur un substrat puis une structuration de ce matériau. Des jonctions Josephson formées sur des substrats SOI (« Silicon On Insulator ») sont connues, par exemple, de A. J. Keller et al., Applied Physics Letters 111, 042603 (2017), et U. Patel et al., Applied Physics Letters 102, 012602 (2013).

Ces réalisations peuvent faire appel à des procédés de gravure qui tendent à introduire des défauts dans le substrat sur lequel la jonction est réalisée.

Un procédé de fraisage par faisceau d'ions argon peut être en particulier utilisé notamment pour éliminer une couche d'oxyde native qui se forme sur les couches minces d'aluminium en raison de leur exposition à l'atmosphère entre deux étapes lithographiques. On cherche généralement à éviter de telles couches d'oxyde qui peuvent s'avérer néfastes pour le résonateur.

Cette étape ainsi que d'autres étapes de gravures sèches peuvent conduire à une dégradation de la couche superficielle du substrat qui peut limiter le temps de cohérence quantique ainsi que le facteur de qualité des résonateurs formés sur ce dernier.

Une manière d'améliorer les performances de tels dispositifs lorsqu'ils sont réalisés sur un substrat en silicium et de se prémunir des conséquences néfastes liées aux procédés de nettoyage et/ou de gravure est, une fois la structure de résonateur réalisée, de venir graver en surface le substrat en silicium dans une région située en regard de la ou des jonctions Josephson et du résonateur.

Une telle gravure se doit d'être maitrisée, notamment en cas de présence de charges pour les performances de la Jonction Josephson. De plus, une telle gravure pose problème notamment dans un cas où l'on souhaite réaliser une co-intégration de la structure avec des composants dans la couche superficielle du substrat.

Il se pose le problème de réaliser un nouveau dispositif pour circuit quantique qui soit amélioré vis-à-vis d'au moins un des inconvénients mentionnés ci-dessus.

### EXPOSÉ DE L'INVENTION

C'est par conséquent un but de la présente invention d'offrir une structure pour dispositif quantique à jonction Josephson comprenant :
- un substrat doté d'une couche superficielle en un matériau semi-conducteur cristallin, en particulier du silicium cristallin,
- au moins une jonction Josephson, formée d'au moins une première portion métallique, en matériau supraconducteur, revêtue d'une zone isolante, ladite zone isolante étant elle-même revêtue d'une deuxième portion métallique en matériau supraconducteur et la deuxième portion métallique recouvrant ladite zone isolante et ladite première portion métallique,
la première portion métallique et la deuxième portion métallique étant disposées sur et en contact d'une couche dite « de protection » agencée sur le substrat ou appartenant au substrat, ladite couche de protection étant une couche de piégeage de charges.

Avec un tel agencement on évite la présence de défauts cristallins dans la couche semi-conductrice superficielle cristalline ou on fait en sorte que d'éventuels défauts dans la couche de protection ou de piégeage de charges ne soient pas préjudiciables à la couche semi-conductrice superficielle cristalline et au fonctionnement du dispositif.

La jonction Josephson est typiquement couplée ou connectée à un résonateur. Avec un agencement tel que défini plus haut, on améliore dans ce cas le facteur de qualité du résonateur.

La couche semi-conductrice cristalline est typiquement une couche de silicium.

Avantageusement, la couche de piégeage de charges de charges est une couche semi-conductrice, en particulier en silicium amorphe hydrogéné (aSi:H) ou en polysilicium ou une couche en matériau diélectrique, en particulier du nitrure de silicium.

Un agencement tel que défini plus haut peut permettre avantageusement de prévoir une couche superficielle du substrat en matériau semi-conducteur cristallin de résistivité faible.

Par résistivité « faible » on entend une résistivité inférieure à 50 Ω.cm et typiquement comprise entre 1 Ω.cm et 20 Ω.cm, en particulier entre 10 Ω.cm et 20 Ω.cm.

La première portion métallique et la deuxième portion métallique sont en un matériau supraconducteur donné, qui peut être en particulier de l'aluminium.

Selon une possibilité de mise en œuvre, la première portion métallique est agencée sur et en contact d'une première piste métallique tandis que la deuxième portion métallique est agencée sur et en contact d'une deuxième piste métallique, la première piste métallique et la deuxième piste métallique étant en un matériau supraconducteur différent dudit matériau supraconducteur donné, ce matériau supraconducteur différent pouvant être en particulier de Niobium.

La couche de piégeage de charges peut être disposée sur la couche superficielle, la couche de piégeage de charges étant en matériau semi-conducteur amorphe ou en matériau polycristallin ou une couche de matériau diélectrique telle que du nitrure de silicium.

Avantageusement, la couche de protection s'étend entièrement en contact de la couche superficielle du substrat.

La première piste métallique ou la deuxième piste métallique peut être reliée ou couplée à un résonateur.

De préférence, la première piste métallique et la deuxième piste métallique sont disposées en regard de ladite couche de protection ou de la couche de piégeage de charges.

Selon une variante de réalisation, la couche de piégeage de charges peut être prévue dans un socle semi-conducteur du substrat, le substrat étant un substrat semi-conducteur sur isolant doté d'une couche isolante agencée entre le socle semi-conducteur et la couche superficielle en matériau semi-conducteur cristallin, la couche isolante et la couche superficielle en matériau semi-conducteur cristallin ne s'étendant pas en regard de ladite jonction Josephson.

Selon un autre aspect, la présente invention concerne un procédé de fabrication d'un dispositif quantique tel que défini précédemment.

Plus particulièrement, selon une première possibilité de mise en œuvre, la présente invention concerne un procédé de fabrication d'une structure telle que définie plus haut et comprenant, dans cet ordre, les étapes suivantes :
- prévoir le substrat doté de la couche superficielle en matériau semi-conducteur cristallin, puis
- déposer la couche de protection ou de piégeage de charges sur ladite couche superficielle, puis
- réaliser sur ladite couche de protection, la première portion métallique, puis la zone isolante sur la première portion métallique, puis la deuxième portion métallique sur la zone isolante.

Avantageusement, la zone isolante peut être formée par oxydation de la première portion métallique.

Selon une possibilité de mise en œuvre, le procédé peut comprendre dans cet ordre, après le dépôt de la couche de protection et préalablement à la formation de la première portion métallique : la formation d'une première piste métallique et d'une deuxième piste métallique sur ladite couche de protection par dépôt puis gravure d'une première couche métallique en un matériau supraconducteur donné.

Selon une deuxième possibilité de mise en œuvre, la présente invention concerne un procédé de fabrication d'une structure telle que définie plus haut et dans lequel le substrat est un semi-conducteur sur isolant doté d'un socle semi-conducteur muni d'une couche de piégeage de charges, d'une couche isolante agencée sur la couche de piégeage de charges et disposée entre le socle semi-conducteur et la couche superficielle en matériau semi-conducteur cristallin, le procédé comprenant des étapes de :
- retrait de la couche la couche superficielle et de la couche isolante dans une zone localisée du substrat, de sorte à dévoiler la couche de piégeage de charges, puis
- réaliser dans ladite zone localisée du substrat, la première portion métallique sur la couche de piégeage de charges, puis la zone isolante sur la première portion métallique, puis la deuxième portion métallique sur la zone isolante.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
Les figures 1A, 1B, 1C, 1D, 1E, 1F, 1G, 1H, 1I illustrent un exemple de réalisation d'un dispositif quantique doté d'une structure formée d'une jonction Josephson couplée à un résonateur et dans lequel une couche de protection est intercalée entre la structure et une couche superficielle en matériau semi-conducteur cristallin d'un substrat.
Les figures 2A-2B illustrent un exemple de réalisation particulier d'une jonction Josephson enrobante.
La figure 3 illustre une variante de réalisation dans laquelle la couche de protection est une couche diélectrique en particulier de type pré-métallique.
La figure 4 illustre une variante de réalisation dans laquelle la jonction est réalisée sur la couche de piégeage d'un substrat de type semi-conducteur sur isolant doté d'une couche de piégeage de charges.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

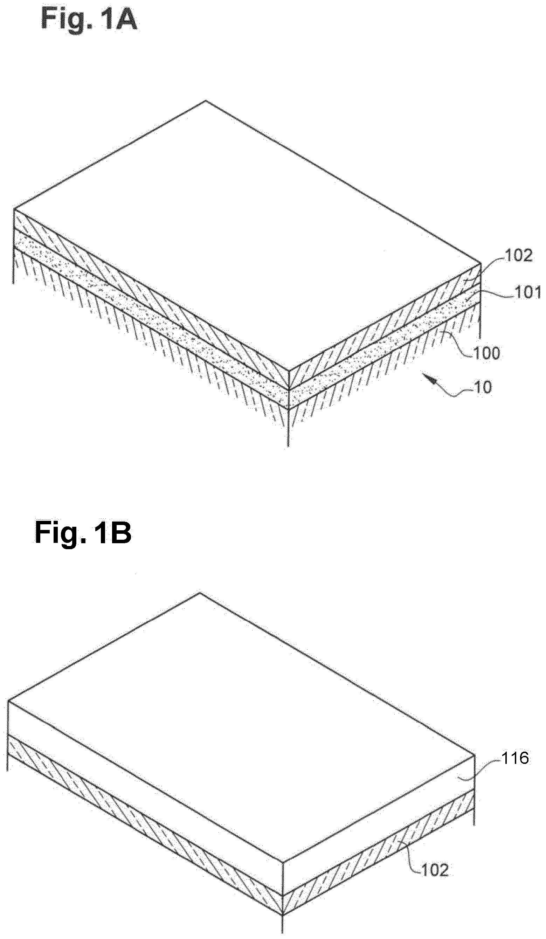

On se réfère tout d'abord à la figure 1A qui donne une vue en coupe d'un exemple de substrat de départ pour la mise en œuvre d'un dispositif quantique, en particulier à Qbits de spin, et doté d'au moins une jonction Josephson couplée ou connectée à un résonateur.

Le substrat 10 est doté d'une la couche superficielle 102 semi-conductrice en matériau semi-conducteur cristallin, en particulier du silicium cristallin. Avantageusement, la couche superficielle 102 peut être ici une couche en matériau semi-conducteur cristallin de faible résistivité, c'est-à-dire de résistivité inférieure à 50 Ω.cm et typiquement comprise entre 1 Ω.cm et 20 Ω.cm.

Selon une possibilité de mise en œuvre et tel que cela est illustré sur l'exemple de réalisation de la figure 1A, le substrat 10 peut être de type semi-conducteur sur isolant, en particulier SOI (« Silicon On Insulator », i.e. Silicium sur isolant) et comporte dans ce cas un socle semi-conducteur 100, une couche isolante enterrée 101, typiquement appelée de BOX (« Buried Oxide » ou « oxyde enterré ») disposée sur le socle semi-conducteur 100 et située entre la couche superficielle 102 semi-conductrice et le socle semi-conducteur 100. La couche superficielle 102 peut être prévue avec une épaisseur comprise par exemple entre 10 nm et 10 µm, avantageusement entre 50 nm et 200 nm.

Selon une étape particulière du procédé, on revêt ici (figure 1B) le substrat 10 d'une couche 116 dite « de protection ». Le matériau de cette couche 116 peut être choisi de préférence de sorte qu'à la fréquence de fonctionnement du résonateur, la couche 116 ait un angle de perte δ_{intrinsèque} faible de sorte que δ_{intrinsèqye} × 10⁶ est compris entre 0.1 et 1000. La fréquence de fonctionnement du résonateur peut être comprise par exemple entre 1 et 10 GHz avantageusement entre 4 et 8 GHz.

Avantageusement, la couche 116 de protection est une couche de piégeage de charges libres. La couche 116 de protection peut être en matériau semi-conducteur amorphe ou en matériau polycristallin et/ou en matériau semi-conducteur poreux.

Selon un mode de réalisation avantageux, la couche 116 de protection peut être prévue en silicium amorphe, en particulier du silicium amorphe hydrogéné (a-SiH). L'épaisseur de la couche 116 de protection peut, dans ce cas, être prévue par exemple entre 10 nm et 10 µm, avantageusement entre 50 nm et 200 nm.

On peut en variante prévoir une couche 116 de protection en polysilicium et/ou en silicium poreux. L'épaisseur de cette couche 116 de protection peut dans ce cas être prévue par exemple entre 10 nm et 10 µm, avantageusement entre 50 nm et 200 nm.

Selon un autre exemple de réalisation, la couche 116 de piégeages de charges peut être un isolant, par exemple un isolant pré-métallique (PMD) tel que du nitrure de silicium (SiₓN_{y} avec x ≠ 0 et y ≠ 0). L'épaisseur de cette couche peut dans ce cas être prévue par exemple entre 10 nm et 10 µm, avantageusement entre 50 nm et 200 nm.

Dans cet exemple de réalisation particulier, la couche 116 de protection est avantageusement déposée pleine plaque et peut recouvrir la couche semi-conductrice superficielle 102 entièrement. Par la suite, la couche 116 de protection est avantageusement préservée sans qu'une gravure ultérieure de cette couche 116 ne soit nécessaire.

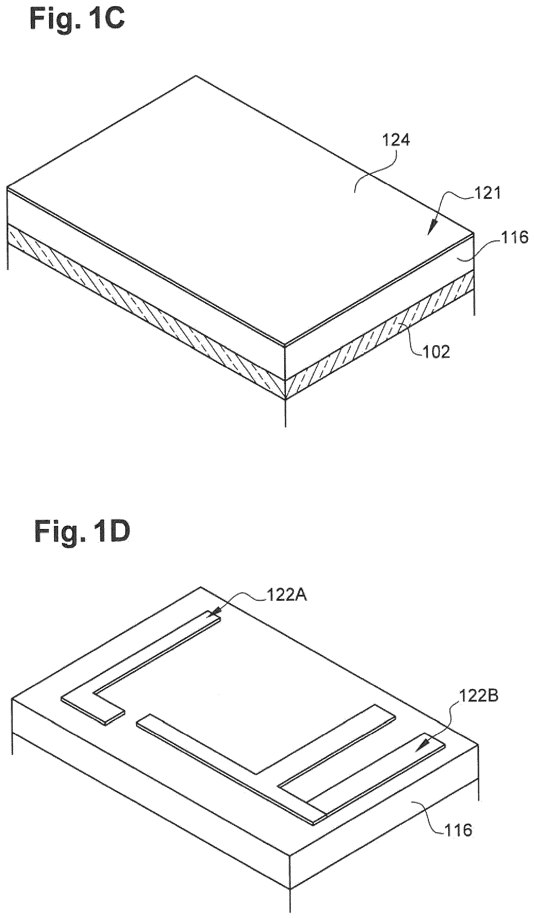

On forme ensuite (figure 1C) sur la couche 116 de protection, une couche 121 métallique en un premier matériau supraconducteur 124, en particulier du Niobium (Nb) ou du nitrure de Tantale (TaN) sur la couche 116 de support. En variante, d'autres matériaux supraconducteurs peuvent être utilisés, par exemple un supraconducteur choisi parmi les suivants : TiN, NbTiN, NbN, AlOx, InOx, silicium fortement dopé ou dégénéré c'est-à-dire avec une concentration supérieure à 10¹⁹ dopants/cm³, Tungstène, ou siliciure de cobalt (CoSi2).

Une couche 121 métallique de Niobium d'épaisseur comprise par exemple entre 1 nm et 1000 nm, par exemple de l'ordre de 150 nm peut être en particulier prévue.

Une gravure (figure 1D) est ensuite réalisée dans la couche 121 métallique de manière à former des pistes métalliques, en particulier une première piste métallique 122A et une deuxième piste deuxième piste métallique 122B.

Typiquement, la gravure est une gravure sèche, en particulier à l'aide d'un plasma et réalisée à travers un masquage (non représenté). Une gravure sèche via un plasma peut être par exemple mise en œuvre.

Une de ces pistes 122A, 122B, peut-être connectée ou couplée à un résonateur par exemple sous forme d'une ligne de transmission hyperfréquence ou d'un ou plusieurs guides d'ondes, conçu(e)(s) pour être le lieu d'oscillations résonantes et qui peu(ven)t être également formé(e)(s) dans la couche 121 métallique.

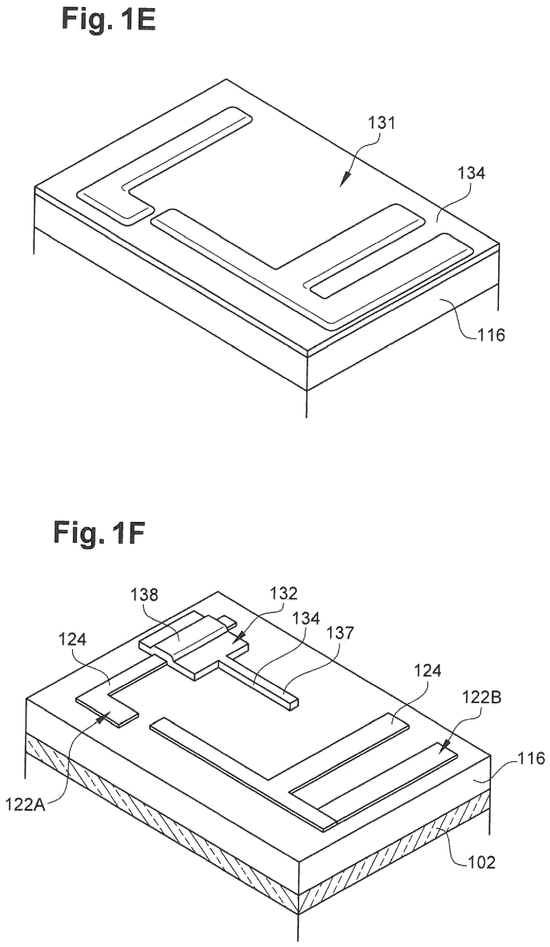

On dépose ensuite (figure 1E) une couche 131 métallique en un deuxième matériau supraconducteur 134, ici différent premier matériau supraconducteur 124, et qui peut être plus aisé à modeler que le premier matériau supraconducteur 124. Le deuxième matériau supraconducteur 134 peut être par exemple de l'aluminium (Al). En variante, d'autres matériaux supraconducteurs peuvent être utilisés, par exemple un supraconducteur choisi parmi les suivants : TiN, TaN, NbTiN, NbN, AlOx, InOx, silicium fortement dopé, Tungstène, ou siliciure de cobalt (CoSi2).

Une couche 131 métallique d'Aluminium d'épaisseur comprise par exemple entre 1 nm et 70 nm, en particulier entre 1 et 10 nm peut être en particulier prévue.

Une gravure (figure 1F) est ensuite réalisée dans la couche 131 métallique de manière à former une ou plusieurs portions métalliques, en particulier au moins une première portion métallique 132 disposée sur une des pistes métalliques 122A, 122B, par exemple sur la première piste 122A précédemment formée. Une gravure sèche à l'aide d'un plasma ou humide et par exemple à l'aide d'une solution chlorée BCl3 peut être mise en œuvre.

La première portion métallique 132 est ici disposée de sorte à chevaucher une partie de la piste conductrice 122A et s'étend ainsi aussi bien sur une face supérieure de la piste conductrice 122A que sur ses faces latérales. Dans l'exemple de réalisation particulier illustré sur la figure 1F, la portion métallique 132 est formée d'une région 138 qui enrobe la piste 122A et d'une région d'extrémité 137 dans le prolongement de cette région 138 par exemple sous forme d'un barreau et qui est rétrécie par rapport à la région 138.

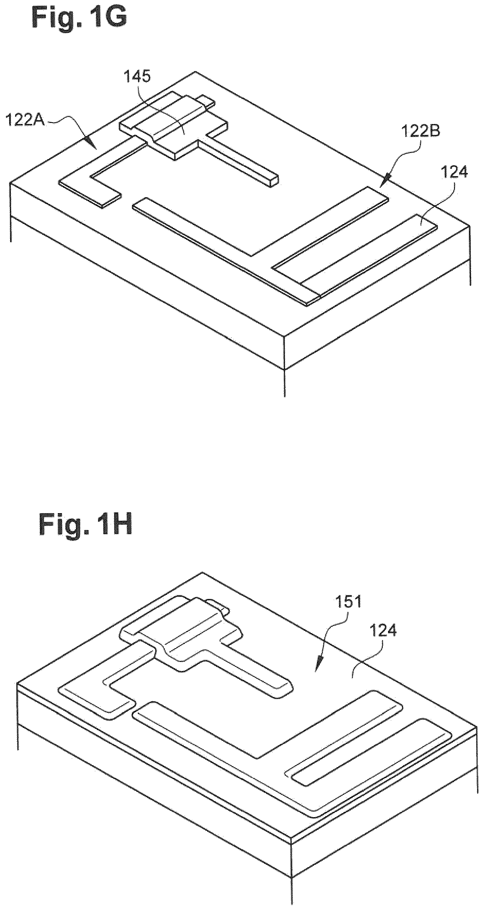

On forme ensuite une zone isolante 145 sur la portion métallique 132. L'exemple de réalisation illustré sur la figure 1G prévoit en particulier la mise en œuvre de cette zone isolante 145 par oxydation du matériau supraconducteur 134, dans cet exemple de l'aluminium. L'oxydation peut être par exemple réalisée à une température de l'ordre de 300°C et sous une atmosphère de l'ordre de 1.33 Pa. L'oxydation du matériau 134, en particulier de l'Aluminium, de la portion métallique 132 est réalisée de préférence tout en préservant le matériau 124 des pistes 122A, 122B, en particulier du Niobium. Pour cela, on prévoit typiquement un masquage recouvrant les pistes 122A, 122B mais comportant au moins une ouverture dévoilant la portion métallique 132.

On dépose ensuite (figure 1G) une couche 151 métallique en matériau supraconducteur, typiquement à base du deuxième matériau supraconducteur 134, ici différent premier matériau supraconducteur 124, et qui peut être de l'aluminium (AI).

Une couche 151 métallique d'Aluminium d'épaisseur comprise par exemple entre 2 nm et 70nm, en particulier entre 10 nm et 30 nm peut être en particulier prévue.

Une gravure (figure 1H) est ensuite réalisée dans la couche 151 métallique de manière à former une ou plusieurs portions métalliques, en particulier au moins une portion métallique 152 disposée sur la deuxième piste 122B, en matériau supraconducteur 124 précédemment formée. Une gravure sèche à l'aide d'un plasma ou humide et par exemple à l'aide par d'une solution chlorée BCl3 peut être mise en œuvre.

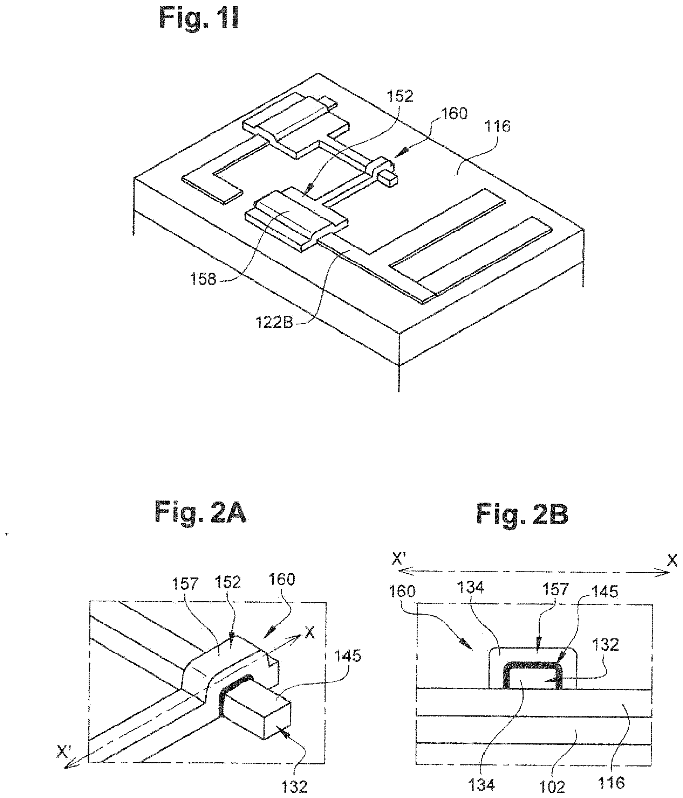

La deuxième portion métallique 152 est ici agencée de sorte à chevaucher une partie de la piste conductrice 122B et s'étend ainsi aussi bien sur une face supérieure de la piste conductrice 122B que sur ses faces latérales. Dans l'exemple de réalisation particulier illustré sur la figure 1I, la portion métallique 152 est formée d'une région 158 qui chevauche la piste 122B et d'une région d'extrémité 157 dans le prolongement de cette région 158 par exemple sous forme d'un barreau et qui est rétrécie par rapport à la région 158. La deuxième portion métallique 152 enrobe, ici par le biais de sa région d'extrémité 157, une partie de la zone isolante 145 et de la première portion métallique 132, en particulier la région d'extrémité 137 de cette portion métallique 132.

Une structure de jonction Josephson 160 dite « enrobante » ou « en pont » comme illustrée sur les vues en perspective des figures 1I et 2A et la vue en coupe transversale (la coupe étant réalisée suivant un axe X'X donné sur la figure 2A) de la figure 2B est ainsi réalisée sur la couche 116 de protection.

La réalisation de cette jonction, et en particulier des portions métalliques 132, 152 peut faire appel en particulier à une ou plusieurs étapes de décapage par fraisage à l'argon (« Ar milling » selon la terminologie anglo-saxonne) et/ou à une ou plusieurs étapes de gravure sèche.

La couche 116 de protection sur laquelle les pistes 122A, 122B et la portion métallique 132 reposent permet alors en particulier de protéger de telles étapes la couche semi-conductrice superficielle 102 du substrat et qui est en matériau semi-conducteur cristallin.

On réalise ici cette jonction Josephson 160 sans avoir à graver la couche 116 de protection et sans devoir réaliser une gravure de parties de la couche superficielle 102 en matériau semi-conducteur cristallin disposées en regard de la jonction Josephson.

On évite ainsi d'introduire des défauts ou des impuretés dans la couche superficielle 102 lors du procédé de fabrication et en particulier lors d'étapes de gravure et/ou de décapage mises en œuvre lors de ce procédé, par exemple pour former les pistes et ou portions métalliques 132, 152, 122A, 122B.

Un avantage de la mise en œuvre de la couche 116 intermédiaire, entre la couche superficielle 102 du substrat et les couches métalliques 131, 151 dans lesquelles on forme la jonction Josephson couplée est qu'elle permet d'obtenir un temps de cohérence amélioré des qubits.

Un avantage de la mise en œuvre de la couche 116 intermédiaire, entre la couche superficielle 102 du substrat et la couche métallique 121 dans lesquelles on forme le résonateur est qu'elle permet d'obtenir un résonateur doté de faibles pertes parasites et de facteur de qualité amélioré.

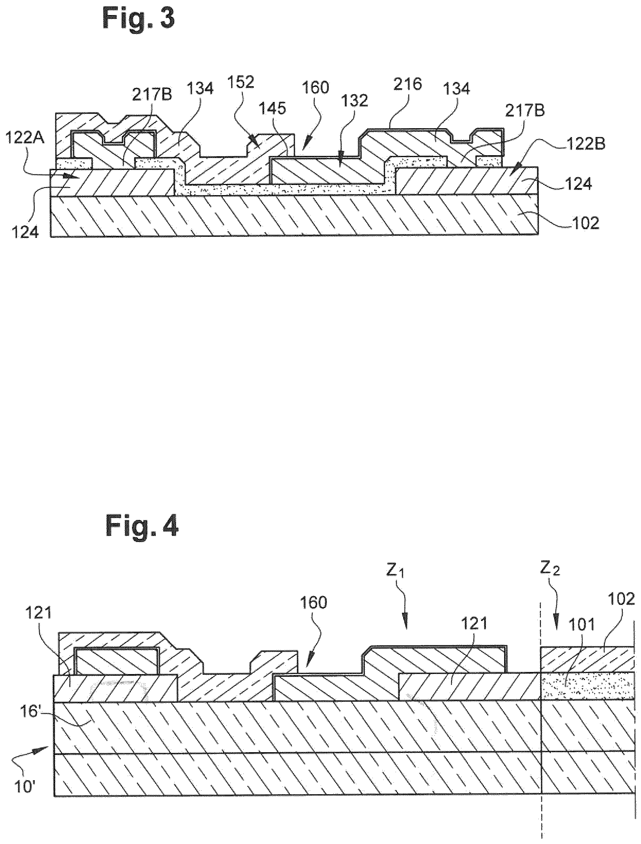

Selon une variante de l'exemple de réalisation décrit précédemment, on peut former une couche de protection 216 telle que décrite précédemment, une fois que les pistes 122A, 122B, en matériau supraconducteur 124, par exemple du Niobium ont été formées. Une telle variante a toutefois pour particularité par rapport à la précédente de requérir, comme cela est illustré sur la structure de la figure 3, la réalisation d'ouvertures 217B dans la couche 216 de protection. De telles ouvertures 217B typiquement formées après de cette couche 216 sont effectuées pour pouvoir permettre de mettre en œuvre un contact avec les portions conductrices 132, 152 de la jonction Josephson 160. Pour une telle variante, la couche de protection 216 peut être par exemple une couche d'isolant PMD tel que nitrure de silicium d'épaisseur par exemple de l'ordre de 20 nm.

Selon une autre variante de réalisation, on peut prévoir de réaliser la jonction Josephson sur une couche de piégeage de charges appartenant cette fois à un substrat 10' et en particulier un substrat de type semi-conducteur sur isolant et muni d'une couche 16' de piégeage de charges et communément appelée « trap rich ». Une telle couche 16' appartient au socle semi-conducteur situé sous la couche isolante 102. Cette couche 16' de piégeage de charges, qui peut être en matériau semi-conducteur polycristallin et en particulier en polysilicium, est typiquement disposée contre et en contact de la couche isolante 101 du substrat 10'.

Pour obtenir un tel agencement, on peut prévoir dans ce cas, de retirer la couche superficielle 102 du substrat 10' et la couche isolante 101 dans une zone localisée Z1 du substrat 10'. La couche superficielle 102 du substrat 10' et la couche isolante 101 sont en revanche préservées dans d'autres zones Z2 du substrat 10'.

Dans l'exemple de réalisation illustré sur la figure 4, aussi bien la jonction Josephson 160 que la couche métallique 121 dans laquelle on le résonateur est réalisé sont formés dans la zone Z1 localisée du substrat 10' sans couche superficielle 102 ni couche isolante 101. Par rapport au procédé décrit précédemment en lien avec les figures 1A-1I, une telle variante a comme particularité qu'elle requiert des étapes de gravure supplémentaires.

Ainsi, on peut partir d'un substrat 10' de type semi-conducteur sur isolant et doté d'une couche de piégeage de charges 16', par exemple un substrat RFeSl^{™} SOI de la société SOITEC, puis déposer un masquage sur une zone Z2 à protéger du substrat et graver dans une zone Z1 localisée dévoilée et non recouverte par le masquage la couche superficielle 12 et la couche isolante 101 de BOX.

Puis, on effectue des étapes telle que décrites précédemment en liaison avec les figures 1C-1I afin de réaliser les pistes métalliques 122A, 122B et la jonction Josephson 160 sur la couche de piégeage de charges 16'.

## Revendications

1. Structure pour dispositif quantique à jonction Josephson comprenant :
- un substrat (10, 10') doté d'une couche superficielle (102) en un matériau semi-conducteur cristallin, en particulier du silicium cristallin,
- au moins une jonction Josephson (160), formée d'au moins une première portion métallique (132), en matériau supraconducteur (134), revêtue d'une zone isolante (145), ladite zone isolante étant elle-même revêtue d'une deuxième portion métallique (152) en matériau supraconducteur (134),
la deuxième portion métallique (152) recouvrant ladite zone isolante (145) et ladite première portion métallique (132),
**caractérisée en ce que**
la première portion métallique (132) et la deuxième portion métallique (152) sont disposées sur et en contact d'une couche (116, 16') dite « de protection » agencée sur le substrat (10) ou appartenant au substrat (10'), ladite couche (116, 16') de protection étant une couche de piégeage de charges.

2. Structure selon la revendication 1, dans lequel la couche (116) de piégeage de charges est en silicium amorphe hydrogéné, aSi:H, ou en polysilicium.

3. Structure selon la revendication 1, dans lequel la couche (116) de piégeage de charges est à base de nitrure de silicium.

4. Structure selon l'une des revendications 1 à 3, dans lequel la couche superficielle (102) du substrat (10) est en matériau semi-conducteur cristallin de résistivité faible et comprise entre 10 Ω.cm et 20 Ω.cm.

5. Structure selon l'une des revendications 1 à 4, dans lequel la couche (116) de protection s'étend entièrement en contact de la couche superficielle (102) du substrat (10).

6. Structure selon l'une des revendications 1 à 5, dans lequel la première portion métallique (132) et la deuxième portion métallique (152) sont en un matériau supraconducteur (134) donné, en particulier de l'aluminium et dans lequel la première portion métallique est agencée sur et en contact d'une première piste métallique (122A), la deuxième portion métallique étant agencée sur et en contact d'une deuxième piste métallique (122B), la première piste métallique et la deuxième piste métallique étant en un matériau supraconducteur (124), différent dudit matériau supraconducteur donné (134).

7. Structure selon l'une des revendications 1 à 6, la couche de piégeage de charges étant disposée sur ladite couche superficielle (102), la couche de piégeage de charges étant en matériau semi-conducteur amorphe (112) ou en matériau polycristallin ou une couche de matériau diélectrique (115) telle que du nitrure de silicium.

8. Structure selon l'une des revendications 1 à 6, la couche (16') de piégeage de charges étant prévue dans un socle semi-conducteur (100) du substrat, le substrat étant un substrat semi-conducteur sur isolant doté d'une couche isolante (101) agencée entre le socle semi-conducteur (10) et la couche superficielle (102) en matériau semi-conducteur cristallin, la couche isolante (101) et la couche superficielle (102) en matériau semi-conducteur cristallin ne s'étendant pas en regard de ladite jonction Josephson (160).

9. Dispositif quantique comprenant une structure selon l'une des revendications 1 à 8, dans lequel un résonateur est couplé à une première piste métallique (122A) ou à une deuxième piste métallique (122B), le résonateur, la première piste métallique (122A) et la deuxième piste métallique (122B) étant disposées en regard de ladite couche (116) de protection.

10. Procédé de fabrication d'une structure selon l'une des revendications 1 à 7, comprenant, dans cet ordre, les étapes suivantes :
- prévoir le substrat (10) doté de la couche superficielle (102) en matériau semi-conducteur cristallin, puis
- déposer la couche (116) de protection sur ladite couche superficielle (102), puis
- réaliser sur ladite couche (116) de protection, la première portion métallique (132), puis la zone isolante (145) sur la première portion métallique (132), puis la deuxième portion métallique (152) sur la zone isolante (145).

11. Procédé selon la revendication 10, dans lequel la zone isolante (145) est formée par oxydation de la première portion métallique (132).

12. Procédé selon l'une des revendications 10 ou 11, comprenant, dans cet ordre, après le dépôt de la couche (116) de protection et préalablement à la formation de la première portion métallique (132), la formation d'une première piste métallique (122A) et d'une deuxième piste métallique (122B) sur ladite couche (116) de protection par dépôt puis gravure d'une première couche métallique (121) en un matériau supraconducteur (124) donné.

13. Procédé de fabrication d'une structure selon la revendication 8, dans lequel le substrat (10) est un semi-conducteur sur isolant doté d'un socle semi-conducteur muni d'une couche (16') de piégeage de charges, d'une couche isolante (101) agencée sur la couche (16') de piégeage de charges et disposée entre le socle semi-conducteur (10) et la couche superficielle (102) en matériau semi-conducteur cristallin, le procédé comprenant des étapes de :
- retrait de la couche la couche superficielle (102) et de la couche isolante (101) dans une zone localisée du substrat (10'), de sorte à dévoiler la couche (16') de piégeage de charges, puis
- réaliser dans ladite zone localisée (Z1) du substrat, la première portion métallique (132) sur la couche (16') de piégeage de charges, puis la zone isolante (145) sur la première portion métallique (132), puis la deuxième portion métallique (152) sur la zone isolante (145).

## Patentansprüche

1. Struktur für eine Quantenvorrichtung mit Josephson-Verbindung, umfassend:
- ein Substrat (10, 10') mit einer Oberflächenschicht (102) aus einem kristallinen Halbleitermaterial, insbesondere kristallinem Silizium,
- mindestens eine Josephson-Verbindung (160), die aus mindestens einem ersten Metallabschnitt (132), aus supraleitendem Material (134), mit einem Isolierbereich (145) beschichtet ist, wobei der Isolierbereich selbst mit einem zweiten Metallabschnitt (152) aus supraleitendem Material (134) beschichtet ist, wobei der zweite Metallabschnitt (152) den Isolierbereich (145) und den ersten Metallabschnitt (132) abdeckt, **dadurch gekennzeichnet, dass** der erste Metallabschnitt (132) und der zweite Metallabschnitt (152) auf und in Kontakt mit einer sogenannten "Schutzschicht" (116, 16') angeordnet sind, die auf dem Substrat (10) angeordnet ist oder zum Substrat (10') gehört, wobei die Schutzschicht (116, 16') eine Ladungseinschlussschicht ist.

2. Struktur nach Anspruch 1, wobei die Ladungseinschlussschicht (116) aus hydriertem amorphem Silizium, aSi:H, oder aus Polysilizium besteht.

3. Struktur nach Anspruch 1, wobei die Ladungseinschlussschicht (116) auf Siliziumnitridbasis ist.

4. Struktur nach einem der Ansprüche 1 bis 3, wobei die Oberflächenschicht (102) des Substrats (10) aus kristallinem Halbleitermaterial mit geringem Widerstand und zwischen 10 Ω.cm und 20 Ω.cm besteht.

5. Struktur nach einem der Ansprüche 1 bis 4, wobei sich die Schutzschicht (116) vollständig in Kontakt mit der Oberflächenschicht (102) des Substrats (10) erstreckt.

6. Struktur nach einem der Ansprüche 1 bis 5, wobei der erste Metallabschnitt (132) und der zweite Metallabschnitt (152) aus einem bestimmten supraleitenden Material (134), insbesondere Aluminium, bestehen und wobei der erste Metallabschnitt auf einer ersten Metallbahn (122A) angeordnet ist und mit dieser in Kontakt steht, wobei der zweite Metallabschnitt auf einer zweiten Metallbahn (122B) angeordnet ist und mit dieser in Kontakt steht, wobei die erste Metallbahn und die zweite Metallbahn aus einem supraleitenden Material (124) bestehen, das sich von dem supraleitenden Material (134) unterscheidet.

7. Struktur nach einem der Ansprüche 1 bis 6, wobei die Ladungseinschlussschicht auf der Oberflächenschicht (102) angeordnet ist, wobei die Ladungseinschlussschicht aus amorphem Halbleitermaterial (112) oder aus polykristallinem Material oder einer Schicht aus dielektrischem Material (115) wie Siliziumnitrid besteht.

8. Struktur nach einem der Ansprüche 1 bis 6, wobei die Ladungseinschlussschicht (16') in einem Halbleitersockel (100) des Substrats vorgesehen ist, wobei das Substrat ein Halbleiter-Isolator-Substrat mit einer Isolierschicht (101) ist, die zwischen dem Halbleitersockel (10) und der Oberflächenschicht (102) aus kristallinem Halbleitermaterial angeordnet ist, wobei die Isolierschicht (101) und die Oberflächenschicht (102) aus kristallinem Halbleitermaterial sich nicht gegenüber der Josephson-Verbindung (160) erstrecken.

9. Quantenvorrichtung umfassend eine Struktur nach einem der Ansprüche 1 bis 8, wobei ein Resonator mit einer ersten Metallbahn (122A) oder einer zweiten Metallbahn (122B) gekoppelt ist, wobei der Resonator, die erste Metallbahn (122A) und die zweite Metallbahn (122B) gegenüber der Schutzschicht (116) angeordnet sind.

10. Verfahren zur Herstellung einer Struktur nach einem der Ansprüche 1 bis 7, das in dieser Reihenfolge folgende Schritte umfasst:
- Vorsehen des Substrats (10), das mit der Oberflächenschicht (102) aus kristallinem Halbleitermaterial beschaffen ist, anschließend
- Auflegen der Schutzschicht (116) auf die Oberflächenschicht (102), anschließend
- Erstellen, auf der Schutzschicht (116), des ersten Metallabschnitts (132), anschließend des Isolierbereichs (145) auf dem ersten Metallabschnitt (132), anschließend des zweiten Metallabschnitts (152) auf dem Isolierbereich (145).

11. Verfahren nach Anspruch 10, wobei der Isolierbereich (145) durch Oxidation des ersten Metallabschnitts (132) gebildet wird.

12. Verfahren nach einem der Ansprüche 10 oder 11, das in dieser Reihenfolge nach dem Ablegen der Schutzschicht (116) und vor der Bildung des ersten Metallabschnitts (132) die Bildung einer ersten Metallbahn (122A) und einer zweiten Metallbahn (122B) auf der Schutzschicht (116) durch Ablagerung und anschließendes Ätzen einer ersten Metallschicht (121) in einem bestimmten supraleitenden Material (124) umfasst.

13. Verfahren zur Herstellung einer Struktur nach Anspruch 8, wobei das Substrat (10) ein Halbleiter-auf-Isolator ist, der über einen Halbleitersockel verfügt, der mit einer Ladungseinschlussschicht (16'), einer Isolationsschicht (101) ausgestattet ist, die auf der Ladungseinschlussschicht (16') angeordnet und zwischen dem Halbleitersockel (10) und der Oberflächenschicht (102) aus kristallinem Halbleitermaterial angeordnet ist, wobei das Verfahren folgende Schritte umfasst:
- Entfernen der Schicht aus der Oberflächenschicht (102) und der Isolierschicht (101) in einem lokalisierten Bereich des Substrats (10'), so dass die Ladungseinschlussschicht (16') offenbart wird, anschließend
- Erstellen, in dem lokalisierten Bereich (Z1) des Substrats, des ersten Metallabschnitts (132) auf der Ladungseinschlussschicht (16'), anschließend des Isolierbereichs (145) auf dem ersten Metallabschnitt (132), anschließend des zweiten Metallabschnitts (152) auf dem Isolierbereich (145).

## Claims

1. A Josephson junction quantum device structure comprising:
- a substrate (10, 10') provided with a surface layer (102) of a crystalline semiconductor material, in particular crystalline silicon,
- at least one Josephson junction (160), formed by at least one first metal portion (132), of a superconducting material (134), coated with an insulating zone (145), said insulating zone itself being coated with a second metal portion (152) of a superconducting material (134), the second metal portion (152) covering said insulating zone (145) and said first metal portion (132), **characterized in that**:
the first metal portion (132) and the second metal portion (152) are disposed on and in contact with a so-called "protective" layer (116, 16') arranged on the substrate (10) or belonging to the substrate (10'), said protective layer (116, 16') being a trap rich layer.

2. The structure according to claim 1, wherein the trap rich layer (116) is of hydrogenated amorphous silicon, aSi:H, or polysilicon.

3. The structure according to claim 1, wherein the trap rich layer (116) is based on silicon nitride.

4. The structure according to one of claims 1 to 3, wherein the surface layer (102) of the substrate (10) is of a crystalline semiconductor material with a low resistivity of between 10 Ω.cm and 20 Ω.cm.

5. The structure according to one of claims 1 to 4, wherein the protective layer (116) entirely extends in contact with the surface layer (102) of the substrate (10).

6. The structure according to one of claims 1 to 5, wherein the first metal portion (132) and the second metal portion (152) are of a given superconducting material (134), in particular aluminium, and wherein the first metal portion is arranged on and in contact with a first metal track (122A), the second metal portion being arranged on and in contact with a second metal track (122B), the first metal track and the second metal track being of a superconducting material (124) different from said given superconducting material (134).

7. The quantum structure according to one of claims 1 to 6, the trap rich layer being disposed on said surface layer (102), the trap rich layer being of an amorphous semiconductor material (112) or polycrystalline material or a layer of dielectric material (115) such as silicon nitride.

8. The structure according to one of claims 1 to 6, the trap rich layer (16') being provided in a semiconducting pedestal (100) of the substrate, the substrate being a semiconductor-on-insulator substrate provided with an insulating layer (101) arranged between the semiconducting pedestal (10) and the surface layer (102) of a crystalline semiconductor material, the insulating layer (101) and the surface layer (102) of crystalline semiconductor material not extending facing said Josephson junction (160).

9. A quantum device comprising a structure according to one of claims 1 to 8, wherein a resonator is coupled to the first metal track (122A) or to the second metal track (122B), the resonator, the first metal track (122A) and the second metal track (122B) being disposed facing said protective layer (116).

10. A method for manufacturing a structure according to one of claims 1 to 7, comprising, in this order, the following steps:
- providing the substrate (10) with the surface layer (102) of crystalline semiconductor material, and then
- depositing the protective layer (116) onto said surface layer (102), and then
- making, on said protective layer (116), the first metal portion (132), and then the insulating zone (145) on the first metal portion (132), and then the second metal portion (152) on the insulating zone (145).

11. The method according to claim 10, wherein the insulating zone (145) is formed by oxidising the first metal portion (132).

12. The method according to one of claims 10 or 11, comprising, in this order, after depositing the protective layer (116) and prior to forming the first metal portion (132), forming a first metal track (122A) and a second metal track (122B) on said protective layer (116) by depositing and then etching a first metal layer (121) of a given superconducting material (124).

13. The method for manufacturing a structure according to claim 8, wherein the substrate (10) is a semiconductor on insulator provided with a semiconducting pedestal provided with a trap rich layer (16'), an insulating layer (101) arranged on the trap rich layer (16') and disposed between the semiconducting pedestal (10) and the surface layer (102) of a crystalline semiconductor material, the method comprising the steps of:
- removing the surface layer (102) and the insulating layer (101) in a localised zone of the substrate (10'), so as to reveal the trap rich layer (16'), and then
- making, in said localised zone (Z1) of the substrate, the first metal portion (132) on the trap rich layer (16'), and then the insulating zone (145) on the first metal portion (132), and then the second metal portion (152) on the insulating zone (145).
